# EUROPEAN PATENT SPECIFICATION

(11) **EP 1 560 252 B1**
(45) Date of publication and mention of the grant of the patent: **09.03.2016**
(21) Application number: 04258095.1
(22) Date of filing: 23.12.2004
(51) Int. Cl.: H01J 37/32, C23C 16/44

(54) **Deposition apparatus**
Abscheidungsgerät
Appareil de dépôt

(30) Priority: 31.12.2003 US 533615 P; 21.12.2004 US 18641
(43) Date of publication of application: 03.08.2005
(73) Proprietor: Edwards Vacuum, LLC, Sanborn, NY 14132 (US)
(72) Inventor: Bailey, Christopher Mark, Pleasanton CA 94588 (US); Hogle, Richard, Oceanside CA 92056 (US); Purdon, Simon, Mountain View CA 94041 (US); Kasmalkar, Revati Pradhan, San Jose CA 95135 (US); Sullivan, Aaron, San Jose CA 95112 (US); Ma, Ce, Cary NC 27519 (US); Wang, Qing Min, Edison NJ 08820 (US)
(74) Representative: Clark, Charles Robert

(56) References cited:
- EP-A1- 1 079 000
- WO-A-02/101805
- JP-A- S61 177 370
- US-A- 5 609 721
- US-A1- 2002 179 247
- US-A1- 2003 017 087
- US-B1- 6 383 300

## Description

The present invention relates to deposition apparatus, and in particular to a method and apparatus for depositing a thin film on a substrate.

Thin film deposition processes for depositing films of pure and compound materials are known. In recent years, the dominant technique for thin film deposition has been chemical vapour deposition (CVD). A variant of CVD, Atomic Layer Deposition (ALD) has been considered to be an improvement in thin layer deposition in terms of uniformity and conformity, especially for low temperature deposition. ALD was originally termed Atomic Layer Epitaxy, for which a competent reference is Atomic Layer Epitaxy, edited by T. Sunola and M. Simpson (Blackie, Glasgo and London, 1990).

Generally, ALD is a process wherein conventional CVD processes are divided into single-monolayer deposition steps, wherein each separate deposition step theoretically goes to saturation at a single molecular or atomic monolayer thickness, and self-terminates. The deposition is the outcome of chemical reactions between reactive molecular precursors and the substrate. In similarity to CVD, elements composing the film are delivered as molecular precursors. The net reaction must deposit the pure desired film and eliminate the "extra" atoms that compose the molecular precursors (ligands).

In the case of CVD, the molecular precursors are fed simultaneously into the CVD reaction chamber. A substrate is kept at a temperature that is optimized to promote chemical reaction between the molecular precursors concurrent with efficient desorption of by-products. Accordingly, the reaction proceeds to deposit the desired thin film.

For ALD applications, the molecular precursors are introduced separately into the ALD reaction chamber. This is done by flowing one precursor (typically a metal to which is bonded an atomic or molecular ligand to make a volatile molecule). The metal precursor reaction is typically followed by inert gas purging to eliminate this precursor from the chamber prior to the introduction of the next precursor.

Thus, in contrast to the CVD process, ALD is performed in a cyclic fashion with sequential alternating pulses of the precursor, reactant and purge gases. Typically, only one monolayer is deposited per operation cycle, with ALD typically conducted at pressures less than 1 Torr.

ALD processes are commonly used in the fabrication and treatment of integrated circuit (IC) devices and other substrates where defined, ultra-thin layers are required. Such ALD processes produce by-products that adhere to and otherwise cause deleterious processing effects in the deposition apparatus components. Such effects include pump seizure, pump failure, impure deposition, impurities adhering to reaction chamber walls, etc. that require the deposition process to be suspended while the by-products are removed, or the fouled components are replaced. The suspension of the production is timely and thus costly.

Such drawbacks also occur in Chemical Vapour Deposition (CVD) processes. However, such problems often occur with greater frequency during ALD since, in ALD processes, the gases fed into the reaction chamber and the intended reaction is a surface reaction on the substrate being treated (e.g., IC devices). Therefore, in ALD processes, a majority of the supplied gas leaves the reaction chamber "unreacted", and further mixes with gases from the previous and subsequent reaction steps. As a result, a significant volume of the unreacted gases is available to react outside the reaction chamber in locations such as in the process foreline and the pumps. It is believed that this condition in ALD processes results in higher unwanted non-chamber deposition rates, which leads to pump and foreline "clogging" and resulting in pump failure with respect to both seizure and restart.

Various solutions have been attempted, but are time-consuming, costly, or otherwise impractical for various reasons including space allocation. For example, one current approach being used fits a valve at the exhaust of the reaction chamber. The valve acts to physically switch the flow alternately to one of two forelines and vacuum pumps. The valve operation must be timed to synchronize with the cycle times used to pulse various gases into the reaction chamber. Each pump exhaust must be routed separately to an abatement unit. As a result, this solution is not desirable due to increased processing cost. In addition, this solution is incomplete as portions of the reactant gases may still combine and react before they reach the chamber's exit valve. Other solutions employ a foreline trap, to either trap the process by-product, or selectively trap one or more of the reactant species to avoid cross-reaction. One proposed solution in a CVD process, disclosed in JP 11181421 introduces CIF3 or F2 to react with by-products formed during CVD that adhere to pipe surfaces. However, the significant amount of by-product exiting the reaction chamber and the expected proportion of reactivity of the species make this approach unworkable for ALD systems. Rather than introduce separate chemical reactions to break down unwanted deposited by-products, it would be more efficient, less disruptive, less costly and therefore much more desirable to impede by-product accumulation in the first instance. Furthermore EP1079000 describes a method of removing residue from a semiconductor processing chamber exhaust line by using a plasma system to volatise trap particles. US 5609721 describes a method and apparatus for cleaning a semiconductor device manufacturing apparatus. US2002/179247 describes a nozzle for introducing reactive species into a remote plasma cleaning apparatus. JPS61177370 discloses an apparatus for preventing a pump clogging by passing either passing water or nitrogen purge between two booster pumps to remove or prevent deposition of process by-products respectively.

In a first aspect, the present invention provides a method of operating a deposition apparatus according to claim 1.

In a second aspect, the present invention provides a deposition apparatus according to claim 13.

The amount of by-products produced as a result of the deposition process can thus be decreased or substantially eliminated by providing a fluorine atmosphere comprising molecular fluorine (F₂) or fluorine in the radical form (F*), and introducing the fluorine atmosphere to the foreline. This can predictably maintain the volatility of produced by-products to prevent unwanted volumes of by-product deposition on the pump, inner surfaces of the lines and chambers, and/or on other component surfaces, and/or to predictably re-volatize any deposited by-products that may have been deposited on pump and component surfaces.

Fluorine gas, either in molecular (F₂) or radical (F*) form, is injected directly into the foreline, preferably at a location in the foreline upstream of the pump. Generally, the volume of gas required is inversely proportional to the reactivity of the gas. Hence, F* would be preferred over elemental fluorine, F₂. However, F* will very quickly recombine to form F₂, although there are design considerations which can affect the rate at which recombination occurs. For the purposes of this invention, the term "fluorine gas" refers to either F₂, or F*, or both unless otherwise indicated.

There are several viable options for the source of the fluorine gas, where to introduce the gas in the foreline, as well as where to introduce the gas directly into the pump, and how the injection system and pump are arranged with respect to the exhaust gas abatement system. The present disclosure therefore contemplates all of these options as would be readily understood by one skilled in the gas processing field.

For example, fluorine gas can be supplied to the apparatus delivered from a gas container, cylinder, or "bottle". However, this is expected only to be acceptable for small-scale investigations to prove the effectiveness of fluorine but for regulatory reasons it is unlikely that the presence of a high pressure fluorine cylinder often will be acceptable.

Further, fluorine gas may be sourced to the apparatus through extraction from a gas stream such as NF₃, C₂F₆, SF₆ or similar using a plasma generator such as the MKS Astron (MKS ASTex Products, Wilmington, MA) or similar device to produce fluorine radicals. The fluorine radicals will recombine to F₂ within a fairly short distance. Another method of separating the F₂ / F radical from the NF₃ / C₂F₆ / SF₆ stream would be to use a hollow cathode, as set forth in detail in U.S Patent No. 5,951, 742.

Still further, a fluorine generator may be provided, located externally from, or integrated within, the apparatus, which electrolyzes aqueous HF into F₂ and H₂. The generator may not require the usually present buffer volume and purification equipment since the present invention may not require highly purified fluorine gas for its intended purpose.

Preferred design considerations include injecting or introducing the fluorine gas at specific locations in the foreline. The fluorine gas stream is introduced between the booster pump and the backing pump, which provides some protection against fluorine backstreaming up the foreline, while giving some fluorine gas exposure to the booster pump.

Some level of purge directly into the backing pump stages may be necessary to allow F* to reach far enough into the pump to be effective. Additionally, the present invention contemplates abatement of the pump exhaust, which would include fluorine. Indeed, the exhaust is ideally treated upon exit from the chamber exhaust for the intended useful purpose of becoming further fluorine source gas, for example, HF or NF₃, for the apparatus, or as a fluorine source for a separate operation (*i.e.,* the present method may also become a fluorine production method that may be stored for other use, or recycled to the present processes). Thus, the first stream source and the second stream source may be sources of material selected to react together to form a by-product. Means may be provided for purifying the by-product. A recycle loop may be provided for directing said by-product to said foreline, and/or a storage chamber may be provided for storing the by-product.

Various regulating, sensing, and monitoring means may be provided for the mitigation of fluorine leaks, and general system compliance and control. Further contemplated considerations and practical advantages include: corrosion of materials of construction including static and dynamic seals; stability of process pressure, facilities connections; interlocking of plasma generator of fluorine generator with cleaning gas supply, vacuum pump and abatement; and sharing of fluorine gas source across the quantity of process pumps used on the tool. It is readily understood that should a system have multiple pumps on-line, the fluorine source and support equipment would be shared across all pumps that require fluorine treatment for cleaning.

As previously noted, a majority of the gas supplied to the deposition chamber remains unreacted. The amount of gas introduced to the chamber may be monitored and controlled, and therefore to provide the desired deposition layer, so that it is known how much unreacted gas exits the chamber. It is therefore possible to monitor and control the amount of fluorine gas provided to the foreline in order to optimize the use of the apparatus.

The component, or first stream, may comprise a material selected from the group consisting of rhenium-containing, molybdenum-containing, titanium-containing and tungsten-containing compounds, and/or an ammonia-containing compound.

Preferred feature of the present invention will now be described, by way of example only, with reference to the accompanying drawings, in which:
Figure 1 is a schematic representation of a deposition apparatus wherein fluorine is sourced from NF₃/C₂F₆/SF₆/CIF₃/F₂ via a plasma generator;
Figure 2 is a schematic representation of a deposition apparatus wherein fluorine is sourced from a fluorine generator;
Figure 3 is a schematic representation of a deposition apparatus wherein fluorine sourced to the system from an F₂ bottle;
Figure 4 is a schematic representation of a deposition apparatus wherein fluorine is sourced from NF₃/C₂F₆/SF₆/CIF₃/F₂ with no dissociation; and
Figure 5 is a schematic representation of a deposition apparatus wherein fluorine sourced from NF₃/C₂F₆/SF₆/CIF₃/F₂ via thermal disassociation.

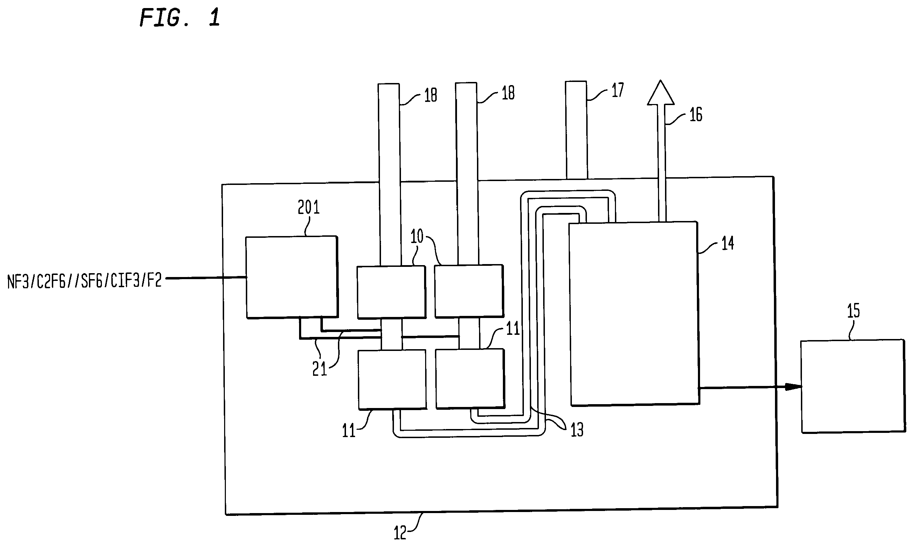

Some embodiments contemplated by the present invention are described below. The most significant differences among the embodiments shown in the Figures 1-5 relate to the location of the fluorine gas sourcing and introduction to the system. In each embodiment the vacuum pumping system comprises a backing pump (11) and booster pump (10) for each foreline (18) - one per wafer reaction or processing chamber on the tool. The pumps exhaust via pipes (13) to an exhaust gas abatement system (14), which is envisaged to be similar in technology and construction to, for example, a thermal oxidizer and wet abatement system. The effluent is piped to the facility exhaust duct (16) while liquid waste is sent to the facility acid waste treatment system (15). The pumps and abatement are housed within an enclosure (12) such as a Zenith style system enclosure, which is extracted to the facility exhaust system via a cabinet extraction system (17). This enclosure is optional for this invention, although it does provide leak detection and containment environments.

In each embodiment described herein as well as those shown in Figures 1-5, fluorine gas (21) is injected between the booster (10) and the backing pump (11).

In each case the effluent from the pumps needs abatement and the addition of fluorine requires suitable abatement, for example using the thermal oxidizer and wet abatement system (14). It is further understood that the fluorine stream can be provided either as a continuous low-level bleed, or as a pulsed flow at higher levels, or as a combination of both.

The potential arrangements of integrating the pumping systems are shown in the Figures. As shown in Figure 1, fluorine is sourced from NF₃/C₂F₆/SF₆/CIF₃/F₂ via a plasma generator (201) such as the MKS Astron, a similar generator, or a plasma generator designed specifically and optimized for these applications. The plasma generator (201) preferably is fed via a pipe from a regulated source of NF₃ or SF₆ or C₂F₆ or the like from a container on a back pad. Alternatively, it could be fed from a regulated source from a point of use fluorine generator situated within the fab or on the back pad. Further, hollow cathodes could be used in this application. See, for example, U.S. Patent No. 5,951,742.

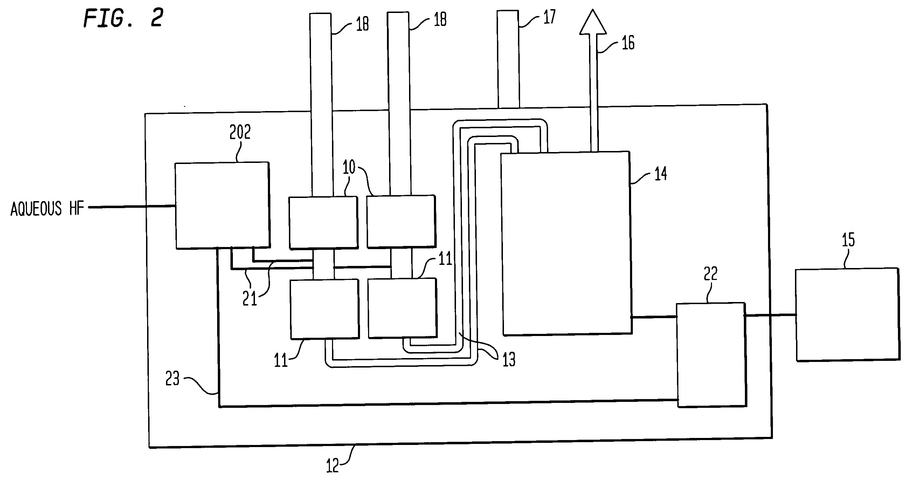

As shown in Figure 2, fluorine may also be sourced from a fluorine generator (202). This embodiment is in most respects the same as that illustrated in Figure1 except that the fluorine source is F₂ electrolytically separated from aqueous HF in the fluorine generator (202). Therefore the output from the fluorine generator (202) is F₂, not F*, as a plasma generator would be required to make F*. Because the liquid output of the gas abatement system contains HF, it is also possible to recover the HF in the waste stream using an HF recovery system (22) and feed back loop (23) to the fluorine generator (202). In this case the pump does not require the purity and flow rate stability that a process chamber does and therefore, some of the components of the typical fluorine generator may be able to be deleted, down rated or shared with other parts of the system. The other elements of this embodiment are the same as those shown in Fig. 1.

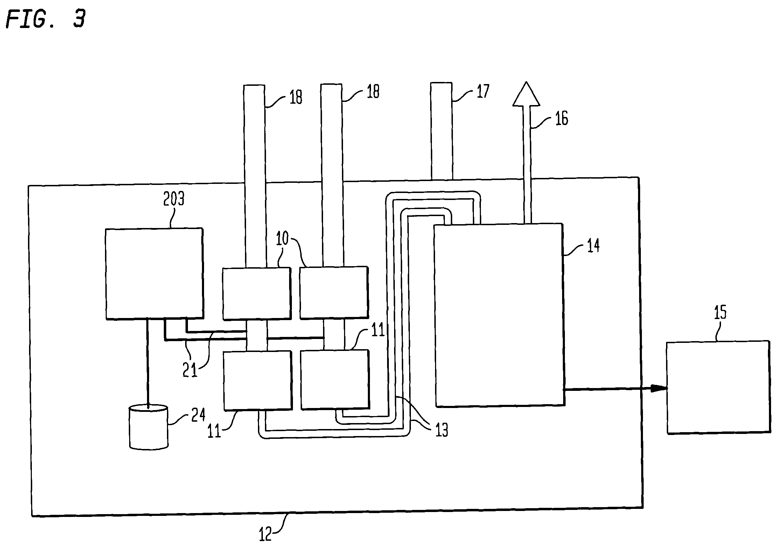

A further embodiment is shown in Figure 3, wherein fluorine gas may be sourced from an F₂ "bottle" (203), (*e.g.,* 20% F₂ in N₂). In this case, fluorine gas is source from a bottle (203) contained within the system enclosure (12) or located in a separate but nearby gas cabinet. This system utilizes a fluorine control and distribution system (30) as will be readily understood by one skilled in the field of gas manufacture and distribution. The other elements of this embodiment are the same as those shown in Fig. 1.

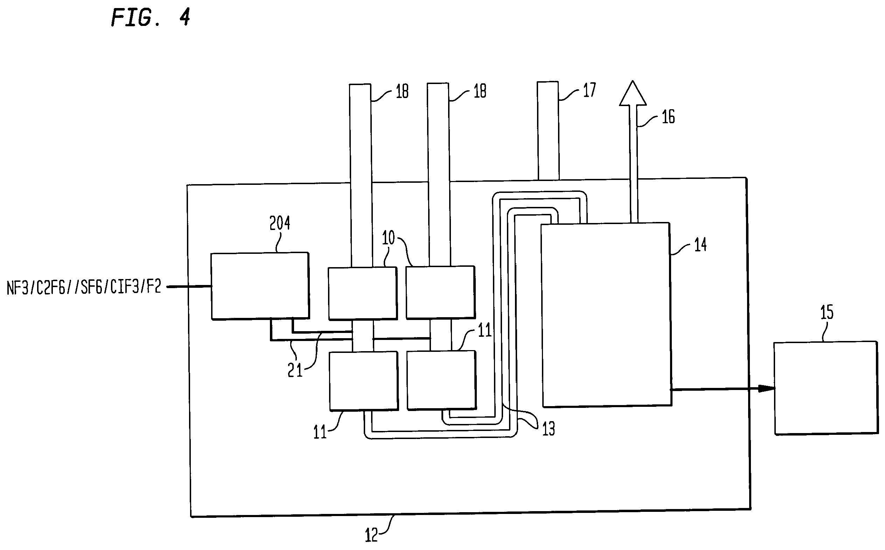

Figure 4 shows an embodiment where fluorine may be sourced from NF₃/C₂F₆/SF₆/CIF₃/F₂ with no dissociation, in which case only a distribution manifold (204) is required, such manifold (204) including the control and monitoring functions. It is also possible that F₂ sourced from an external source could be used in the same manner. The other elements of this embodiment are the same as those shown in Fig. 1.

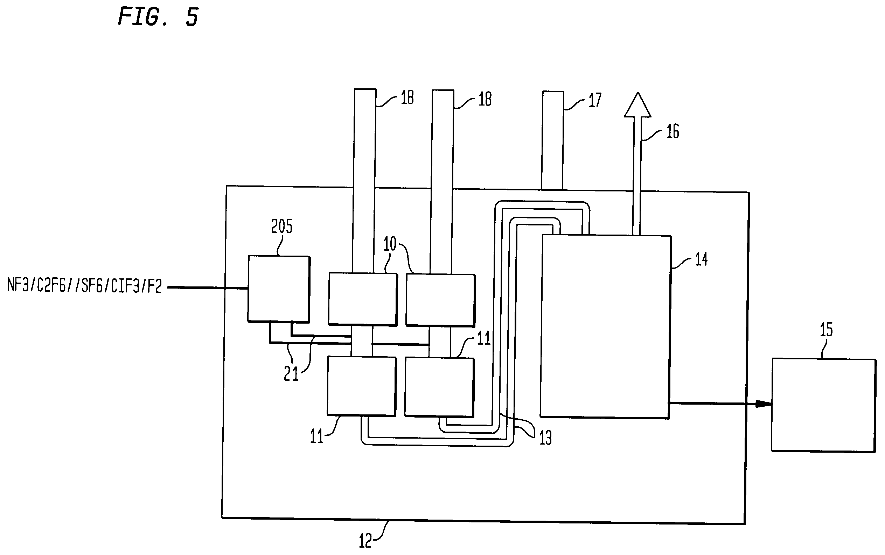

As shown in Figure 5, fluorine may also be sourced from NF₃/C₂F₆/SF₆/CIF₃/F₂ via thermal disassociation using a thermal cracker (205). The other elements of this embodiment are the same as those shown in Fig. 1.

The methods, systems and apparatuses of the present invention are particularly useful in ALD processes for tungsten deposition as both tungsten nucleation layers and tungsten barrier layers where ammonia-containing species are or are not present. See U.S. Patent No. 6,635,965.

When ammonia-containing species are present, the fluorine gas stream will react predictably and in a controlled reaction to produce desired by-products HF and NF₃, which can be isolated downstream and either recycled to the system as further fluorine sources, or delivered to storage facilities for storage or further purification.

### EXAMPLES

Test results confirming the viability of the solutions offered by the present invention were obtained, and are shown in Table 1 below.

**Table 1**

| Run # | F₂ | NF₃ | Ar | Temp | Plasma | Etch | Time | Pressure |
|---|---|---|---|---|---|---|---|---|
| | slm | slm | slm | C | | | min | torr |
| 0 | | 1 | 1 | 30 | yes | fast | | 2.3 |
| 1 | 0.5 | | 5 | 50 | no | none | 10 | 1.97 |
| 1a | 1 | | 1 | 50 | yes | fast | 6 | 2 |
| 2 | 1 | | 1 | 70 | no | none | 10 | 13 |
| 3 | | 1 | 1 | 70 | no | none | 6 | 22.9 |
| 4 | 0.5 | | 5 | 30 | yes | slow | | 43 |
| 5 | 0.5 | | 5 | 30 | yes | slow | | 3.7 |
| 6 | 0.5 | | 2 | 30 | yes | slow | | 3.3 |
| 7 | 1.5 | | 1.5 | 30 | yes | slow | | 30 |
| 7a | 1.77 | | 1.7 | 30 | yes | fast | | 5.6 |

The invention is defined by the claims. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of operating a deposition apparatus comprising a reaction chamber, said chamber having an inlet, and an exhaust in communication with a foreline (18), said foreline being in communication with a backing pump (11), and a booster pump (10), the method comprising the steps of providing a substrate to said chamber, introducing a component to be deposited onto said substrate to said chamber, depositing said component onto said substrate, and introducing a fluorine-containing component to said foreline
**characterised in that**
said fluorine-containing component is introduced between said backing pump and said booster pump.

2. A method according to Claim 1, wherein said fluorine-containing component is selected from the group consisting of fluorine and fluorine radicals.

3. A method according to Claim 1 or Claim 2, wherein said fluorine-containing component is provided from a fluorine source apparatus selected from the group consisting of a fluorine container, a fluorine generator, and a fluorine plasma generator.

4. A method according to any preceding claim, wherein said fluorine-containing component is generated from a fluorine precursor selected from the group consisting of F₂, NF₃, C₂F₆, SF₆, and CIF₃.

5. A method according to any preceding claim, wherein said component comprises a material selected from the group consisting of rhenium-containing, molybdenum-containing, titanium-containing and tungsten-containing compounds.

6. A method according to any of Claims 1 to 4, wherein said component comprises an ammonia-containing compound.

7. A method according to any preceding claim, further comprising the steps of providing said component in a first stream flow at a predetermined amount such that a portion of said first stream remains unreacted and exits said chamber from said exhaust, contacting said unreacted portion of said first stream with said fluorine-containing component in said foreline, and creating a by-product from a reaction of said first stream and said fluorine-containing component.

8. A method according to Claim 7, wherein said by-product is purified.

9. A method according to Claim 7 or Claim 8, wherein said by-product is HF or NF₃.

10. A method according to any of Claims 7 to 9, wherein said by-product is recycled for use in the deposition process.

11. A method according to any of Claims 7 to 9, wherein said by-product is stored.

12. A method according to any preceding claim, wherein said deposition method is selected from the group consisting of chemical vapour deposition and atomic layer deposition.

13. Deposition apparatus comprising a reaction chamber; a backing pump (11); a foreline (18); and a booster pump (10); said chamber having an inlet, and an exhaust in communication with said foreline (18), said foreline being in communication with said booster pump (10) and said backing pump (11); a first stream source in communication with said inlet arranged to provide a first stream to said chamber; a second stream source (201-204) in communication with said foreline arranged to provide a second stream to said foreline **characterised in that** the deposition apparatus further comprises means arranged to regulate said first stream and said second stream such that said second stream is provided to said foreline in an amount sufficient to react with an amount of said first stream and means (21) arranged to introduce said second stream between said backing pump and said booster pump and wherein said second stream source is a source of one of fluorine and fluorine radicals.

14. Apparatus according to Claim 13 wherein said second stream source is selected from the group consisting of a fluorine container, a fluorine generator, and a fluorine plasma generator.

15. Apparatus according to any of Claims 13 to 14, wherein said second stream source is arranged to generate the fluorine-containing compound from a fluorine precursor selected from the group consisting of F₂, NF₃, C₂F₆, SF₆, and CIF₃.

16. Apparatus according to any of Claims 13 to 15, wherein said first stream source is a source of material selected from the group consisting of rhenium-containing, molybdenum-containing, titanium-containing and tungsten-containing compounds.

17. Apparatus according to any of Claims 13 to 15, wherein said first stream source is a source of an ammonia-containing compound.

18. Apparatus according to any of Claims 13 to 17, wherein said apparatus is selected from the group consisting of chemical vapour deposition apparatus and atomic layer deposition apparatus.

19. Apparatus according to any of Claims 13 to 18, wherein said first stream source and said second stream source are sources of material selected to react together to form a by-product.

20. Apparatus according to Claim 19, comprising means for purifying the by-product.

21. Apparatus according to Claim 19 or Claim 20, wherein said by-product is HF or NF₃.

22. Apparatus according to any of Claims 19 to 21, further comprising a recycle loop for directing said by-product to said foreline.

23. Apparatus according to any of Claims 19 to 22, further comprising a storage chamber for storing said by-product.

## Patentansprüche

1. Verfahren zum Betrieb einer Auftragseinrichtung mit einer Reaktionskammer, wobei die Kammer einen Einlaß hat und einen Auslaß in Verbindung mit einer Vorleitung (18), wobei die Vorleitung in Verbindung mit einer Stützpumpe (11) steht, und mit einer Hilfspumpe (10), wobei das Verfahren die Schritte des Einbringens eines Substrats in die genannte Kammer, des Einleitens einer auf das Substrat aufzutragenden Komponente in die genannte Kammer, des Auftragens der genannten Komponente auf das Substrat, und des Einleitens einer fluorhaltigen Komponente in die genannte Vorleitung umfasst, **dadurch gekennzeichnet, dass** die fluorhaltige Komponente zwischen der genannten Stützpumpe und der genannten Hilfspumpe eingeleitet wird.

2. Verfahren nach Anspruch 1, wobei die fluorhaltige Komponente aus der aus Fluor und Fluor-Radikalen bestehenden Gruppe ausgewählt ist.

3. Verfahren nach Anspruch 1 oder Anspruch 2, wobei die genannte fluorhaltige Komponente aus einer Fluorquellen-Einrichtung bereitgestellt wird, die aus der Gruppe, bestehend aus einem Fluorbehälter, einem Fluorgenerator, und einem Fluorplasmagenerator, ausgewählt ist.

4. Verfahren nach irgendeinem vorhergehenden Anspruch, wobei die genannte fluorhaltige Komponente aus einem Fluorvorläufer erzeugt wird, der aus der Gruppe, bestehend aus F₂, NF₃, C₂F₆, SF₆, und ClF₃, ausgewählt ist.

5. Verfahren nach irgendeinem vorhergehenden Anspruch, wobei die genannte Komponente ein Material umfasst, das aus der Gruppe, bestehend aus Rhenium enthaltenden, Titan enthaltenden und Wolfram enthaltenden Verbindungen, ausgewählt ist.

6. Verfahren nach einem der Ansprüche 1 bis 4, wobei die genannte Komponente eine Ammoniak enthaltende Verbindung ist.

7. Verfahren nach irgendeinem vorhergehenden Anspruch, weiter mit den Schritten des Bereitstellens der genannten Komponente in einer ersten Strömung mit einer vorgegebenen Menge, derart, dass ein Teil der ersten Strömung unreagiert bleibt und die Kammer durch den genannten Auslaß verläßt, des Zusammenbringens des genannten unreagierten Teils der ersten Strömung mit der genannten fluorhaltigen Komponente in der Vorleitung, und Erzeugen eines Nebenprodukts aus einer Reaktion der ersten Strömung und der fluorhaltigen Komponente.

8. Verfahren nach Anspruch 7, wobei das Nebenprodukt gereinigt wird.

9. Verfahren nach Anspruch 7 oder Anspruch 8, wobei das Nebenprodukt HF oder NF₃ ist.

10. Verfahren nach einem der Ansprüche 7 bis 9, wobei das Nebenprodukt zur Verwendung in dem Auftragsprozeß rezirkuliert wird.

11. Verfahren nach einem der Ansprüche 7 bis 9, wobei das Nebenprodukt gespeichert wird.

12. Verfahren nach irgendeinem vorhergehenden Anspruch, wobei das Auftragsverfahren aus der Gruppe, bestehend aus chemischer Bedampfung und atomarem Schichtauftrag, ausgewählt ist.

13. Auftragseinrichtung mit einer Reaktionskammer, einer Stützpumpe (11), einer Vorleitung (18) und einer Hilfspumpe (10), wobei die Kammer einen Einlaß hat und einen Auslaß in Verbindung mit der Vorleitung (18), wobei die Vorleitung in Verbindung mit der Hilfspumpe (10) und der Stützpumpe (11) steht, mit einer ersten Strömungsquelle in Verbindung mit dem Einlaß, die dafür angeordnet ist, eine erste Strömung zu der Kammer bereitzustellen, einer zweiten Strömungsquelle (201-204) in Verbindung mit der Vorleitung, die dafür angeordnet ist, eine zweite Strömung zu der Vorleitung bereitzustellen, **dadurch gekennzeichnet, dass** die Auftragseinrichtung weiter Mittel aufweist, die dafür angeordnet sind, die erste Strömung und die zweite Strömung derart zu regulieren, dass die zweite Strömung in die Vorleitung in einer Menge bereitgestellt wird, die ausreichend ist, mit einer Menge der ersten Strömung zu reagieren, und Mittel (21) dafür angeordnet sind, die zweite Strömung zwischen der Stützpumpe und der Hilfspumpe einzuleiten, und wobei die zweite Strömungsquelle eine Quelle von Fluor oder Fluor-Radikalen ist.

14. Einrichtung nach Anspruch 13, wobei die zweite Strömungsquelle aus der Gruppe, bestehend aus einem Fluorbehälter, einem Fluorgenerator, und einem Fluorplasmagenerator, ausgewählt ist.

15. Einrichtung nach einem der Ansprüche 13 bis 14, wobei die zweite Strömungsquelle dafür angeordnet ist, die fluorhaltige Verbindung aus einem Fluorvorläufer zu erzeugen, der aus der Gruppe, bestehend aus F₂, NF₃, C₂F₆, SF₆, und ClF₃, ausgewählt ist.

16. Einrichtung nach einem der Ansprüche 13 bis 15, wobei die erste Strömungsquelle eine Quelle von Material ist, das aus der Gruppe, bestehend aus Rhenium enthaltenden, Molybdän enthaltenden, Titan enthaltenden und Wolfram enthaltenden Verbindungen, ausgewählt ist.

17. Einrichtung nach einem der Ansprüche 13 bis 15, wobei die erste Strömungsquelle eine Quelle einer Ammoniak enthaltenden Verbindung ist.

18. Einrichtung nach einem der Ansprüche 13 bis 17, wobei die Einrichtung aus der Gruppe, bestehend aus einer chemischen Bedampfungseinrichtung und einer Atomschicht-Auftragseinrichtung, ausgewählt ist.

19. Einrichtung nach einem der Ansprüche 13 bis 18, wobei die erste Strömungsquelle und die zweite Strömungsquelle Quellen von Material sind, die so ausgewählt sind, dass sie zusammen zur Bildung eines Nebenprodukts reagieren.

20. Einrichtung nach Anspruch 19, mit Mitteln zum Reinigen des Nebenprodukts.

21. Einrichtung nach Anspruch 19 oder Anspruch 20, wobei das Nebenprodukt HF oder NF₃ ist.

22. Einrichtung nach einem der Ansprüche 19 bis 21, weiter mit einer Rezirkulationsschleife zum Leiten des Nebenprodukts in die Vorleitung.

23. Einrichtung nach einem der Ansprüche 19 bis 22, weiter mit einer Speicherkammer zum Speichern des Nebenprodukts.

## Revendications

1. Procédé de fonctionnement d'un appareil de dépôt comprenant une chambre de réaction, ladite chambre ayant une arrivée, et une évacuation en communication avec une conduite de refoulement (18), ladite conduite de refoulement étant en communication avec une pompe à vide primaire (11), et une pompe à vide secondaire (10), le procédé comprenant les étapes consistant à fournir un substrat à ladite chambre, à introduire un composant à déposer sur ledit substrat dans ladite chambre, à déposer ledit composant sur ledit substrat, et à introduire un composant fluoré dans ladite conduite de refoulement primaire **caractérisé en ce que** ledit composant fluoré est introduit entre ladite pompe à vide primaire et ladite pompe à vide secondaire.

2. Procédé selon la revendication 1, dans lequel ledit composant fluoré est choisi dans le groupe constitué par le fluor et des radicaux de fluor.

3. Procédé selon la revendication 1 ou la revendication 2, dans lequel ledit composant fluoré est fourni à partir d'un appareil source de fluor choisi dans le groupe constitué par un contenant de fluor, un générateur de fluor, et un générateur de plasma fluoré.

4. Procédé selon l'une quelconque des revendications précédentes, dans lequel ledit composant fluoré est généré à partir d'un précurseur fluoré choisi dans le groupe constitué par le F₂, le NF₃, le C₂F₆, le SF₆, et le ClF₃.

5. Procédé selon l'une quelconque des revendications précédentes, dans lequel ledit composant comprend un matériau choisi dans le groupe constitué par des composés à base de rhénium, à base de molybdène, à base de titane et à base de tungstène.

6. Procédé selon l'une quelconque des revendications 1 à 4, dans lequel ledit composant comprend un composé à base d'ammoniac.

7. Procédé selon l'une quelconque des revendications précédentes, comprenant en outre les étapes consistant à fournir ledit composant dans un flot de premier flux en une quantité prédéterminée de sorte qu'une portion dudit premier flux reste sans réaction et quitte ladite chambre à travers ladite évacuation, mettant en contact ladite portion non réagie dudit premier flux avec ledit composant fluoré dans ladite conduite de refoulement, et créant un sous-produit à partir d'une réaction dudit premier flux et dudit composant fluoré.

8. Procédé selon la revendication 7, dans lequel ledit sous-produit est purifié.

9. Procédé selon la revendication 7 ou la revendication 8, dans lequel ledit sous-produit est du HF ou du NF₃.

10. Procédé selon l'une quelconque des revendications 7 à 9, dans lequel ledit sous-produit est recyclé pour être utilisé dans le processus de dépôt.

11. Procédé selon l'une quelconque des revendications 7 à 9, dans lequel ledit sous-produit est stocké.

12. Procédé selon l'une quelconque des revendications précédentes, dans lequel ledit procédé de dépôt est choisi dans le groupe constitué par le dépôt chimique en phase vapeur et le dépôt par couches atomiques.

13. Appareil de dépôt comprenant une chambre de réaction ; une pompe à vide primaire (11) ; une conduite de refoulement (18) ; et une pompe à vide secondaire (10) ; ladite chambre ayant une arrivée, et une évacuation en communication avec ladite conduite de refoulement (18), ladite conduite de refoulement étant en communication avec ladite pompe à vide secondaire (10) et ladite pompe à vide primaire (11) ; une première source de flux en communication avec ladite arrivée agencée pour fournir un premier flux à ladite chambre ; une seconde source de flux (201-204) en communication avec ladite conduite de refoulement primaire agencée pour fournir un second flux à ladite conduite de refoulement primaire **caractérisé en ce que** l'appareil de dépôt comprend en outre des moyens agencés pour réguler ledit premier flux et ledit second flux de sorte que ledit second flux est fourni à ladite conduite de refoulement primaire en quantité suffisante pour réagir avec une quantité dudit premier flux et des moyens (21) agencés pour introduire ledit second flux entre ladite pompe à vide primaire et ladite pompe à vide secondaire et dans lequel ladite seconde source de flux est une source de fluor ou de radicaux de fluor.

14. Appareil selon la revendication 13, dans lequel ladite seconde source de flux est choisie dans le groupe constitué par un contenant de fluor, un générateur de fluor, et un générateur de plasma fluoré.

15. Appareil selon l'une quelconque des revendications 13 à 14, dans lequel ladite seconde source de flux est agencé pour générer le composé fluoré à partir d'un précurseur fluoré choisi dans le groupe constitué par le F₂, le NF₃, le C₂F₆, le SF₆, et le ClF₃.

16. Appareil selon l'une quelconque des revendications 13 à 15, dans lequel ladite première source de flux est une source de matériau choisi dans le groupe constitué par des composés à base de rhénium, à base de molybdène, à base de titane et à base de tungstène.

17. Appareil selon l'une quelconque des revendications 13 à 15, dans lequel ladite première source de flux est une source d'un composé à base d'ammoniac.

18. Appareil selon l'une quelconque des revendications 13 à 17, dans lequel ledit appareil est choisi dans le groupe constitué par un appareil de dépôt chimique en phase vapeur et un appareil de dépôt par couches atomiques.

19. Appareil selon l'une quelconque des revendications 13 à 18, dans lequel ladite première source de flux et ladite seconde source de flux sont des sources de matériaux choisis pour réagir ensemble pour former un sous-produit.

20. Appareil selon la revendication 19, comprenant des moyens pour purifier le sous-produit.

21. Appareil selon la revendication 19 ou la revendication 20, dans lequel ledit sous-produit est du HF ou du NF₃.

22. Appareil selon l'une quelconque des revendications 19 à 21, comprenant en outre une boucle de recyclage destinée à diriger ledit sous-produit vers ladite conduite de refoulement.

23. Appareil selon l'une quelconque des revendications 19 à 22, comprenant en outre une chambre de stockage pour stocker ledit sous-produit.
